# EUROPEAN PATENT APPLICATION

(11) **EP 1 785 498 A2**
(43) Date of publication of application: **16.05.2007**
(21) Application number: 06023584.3
(22) Date of filing: 13.11.2006
(51) Int. Cl.: C22C 13/00, B23K 35/26

(54) **Solder alloy, solder ball, and solder joint using the same**

(30) Priority: 15.11.2005 JP 2005330578
(71) Applicant: HITACHI METALS, LTD., Minato-ku, Tokyo 105-8614 (JP)
(72) Inventor: Date, Masayoshi, Yasugi-shi Shimane (JP); Fujiyoshi, Masaru, Yasugi-shi Shimane (JP)
(74) Representative: Strehl Schübel-Hopf & Partner

(57) **Abstract**

A solder alloy is provided, which consists of, by mass%: 0.6 to 0.75% of Cu; 0.3 to 1.5% of Ag; more than 0.01% but not more than 0.1% of Ge; and the balance being Sn and incidental impurities. Preferably, an amount of Ag is 0.5 to 1 mass%. Preferably, an amount of Ge is more than 0.01 mass% but not more than 0.06 mass%. The solder alloy is preferably spherically formed into a solder ball. A solder joint in which the solder alloy is joined to a Ni electrode is also provided.

## Description

### Technical Field

The present invention relates to a solder alloy used in soldering of electronic parts, etc., a solder ball, and a solder joint.

### Background of the Invention

In recent years, as mobile devices such as cellular phone, etc. are decreased in mount area, there is a tendency of miniaturization in semiconductor packages. A mount configuration, in which a semiconductor package is connected to a mother board, has undergone changes to a type in which electrodes are formed area array package, from a peripheral type in which conventional lead-frame is used. BGA (Ball Grid Array) is a typical one and its electrodes are joined to a mother board by means of spherically formed solder, that is, solder balls.

Different external forces are sometimes applied to a semiconductor package. For example, a drop impact is listed as an external force peculiar to mobile devices. This is because a mobile device is carelessly dropped when it is used or carried. With conventional peripheral type packages, lead-frame is deformed to thereby enable lessening such external force. On the other hand, since BGA is joined directly to a mother board by means of solder balls without lead-frame, it is required that solder joints absorb an external force in order to prevent a semiconductor package and a mother board from being broken. Consequently, reliability in solder joints when a drop impact is applied is very important in extending a mobile device in service life.

Meanwhile, a lead-free solder material is recommended all over the world as one of activities to an environmental problem in recent years, typified by RoHS (the restriction of the use of certain hazardous substances) Directive of EU, and the use of Sn-Pb eutectic solder, which has been conventionally used, is being inhibited. Sn alloys, such as Sn-3Ag-0.5Cu, Sn-3.5Ag-0.75Cu, etc., which contains 3 to 4 mass% of Ag and 0.5 to 0.75 mass% of Cu, are listed as a main one of alternate solders. While Sn has a melting point of 232°C, the melting point can be lowered to around 220°C by addition of Ag and Cu whereby a soldering temperature is made low to enable suppressing thermal damage to semiconductor packages.

Since Ag and Cu in Sn form an intermetallic compound with Sn to harden solder, however, ductility is poor as compared with conventional Sn-Pb eutectic solder. Consequently, there is caused a serious problem that fracture is liable to occur along a solder joint interface when a mobile device is dropped. Thus, a lead-free solder material, which is excellent in drop impact strength, is rapidly demanded.

The following two approaches are conceived as a method of improving a solder joint in impact strength. One of them is to improve solder in ductility to be well deformed, which is achieved by reducing the amount of Ag and Cu in Sn. An eutectic composition having a lowest melting point is provided by adding 3.5 mass% of Ag and 0.75 mass% of Cu to Sn respectively. Addition of a larger amount of Ag than that of Cu greatly acts to harden the solder. Hereupon, JP-A-11-221695 and JP-A-2000-190090 improve mechanical properties of solder by the use of a Sn-Cu alloy containing no Ag.

The other approach is improvement of strength of a solder joint interface is conceived as another measures. It is reported in W.T. Chen et al. (Journal of Materials Research, 17 (2002) 263) that when a Sn-Cu alloy containing not less than 0.7 mass% of Cu is soldered to Ni, a Cu-Ni-Sn compound formed on a solder joint interface does not spall off of Ni, and so a stable joint is obtained. Furthermore, JP-A-11-221695 clarifies that in the case where solder containing Cu much is joined to a Cu electrode, it is possible to inhibit the significant dissolution of the Cu electrode, and so the joint strength is improved.

### Summary of the Invention

In this manner, Sn-Cu alloys have an advantage that they have lower melting point than Sn, so that they can suppress thermal damage to semiconductor packages at the time of soldering, and exhibit a stable joint strength when joined to Ni electrodes and Cu electrodes. As a result of examination of Sn-Cu alloys by the inventors of the present application, however, there have been caused a problem that failure is observed in a high probability at the time of visual examination since large irregularities are present on solder surfaces and a favorable metallic luster disappears.

Solder balls used in joining of BGA are mounted on electrodes of BGA and then heated and melted. When irregularities are present on their surfaces, they cannot be favorably mounted on electrodes of BGA, which greatly mar productivity. Furthermore, even in the case where solder balls can be mounted and joined somehow, there are frequently caused problems that failure is judged in visual examination since irregularities are severely present on solder surface structures after joining in the same manner as on balls, and that correct values cannot be measured since laser beams are not reflected well in measuring dispersion in solder level. Consequently, semiconductor packages are greatly decreased in productivity and yield ratio.

In addition, since large surface irregularities increase the probability of be exposed to an outside air, surface of solder is liable to be oxidized. Therefore, in the case where an associated device is used in high-temperature environment or a semiconductor package generates a large quantity of heat, there is a problem that solder is liable be oxidized and metallic luster is consequently marred further.

In the case where a Sn-Cu alloy containing a large amount of Cu is soldered to a Ni electrode, a Cu-Ni-Sn compound formed on a solder joint interface does not spall off of the Ni electrode, and so a stable strength is exhibited. It has been found, however, that in case of being exposed to high temperature for a long time due to heat generation from a semiconductor package, etc., a Cu-Ni-Sn compound grows to become thick and the joint strength is instead deteriorated.

It is an object of the invention to solve problems such as a bad surface texture of a Sn-Cu alloy which leads to judgment of failure in visual examination and failure in mounting of solder balls. The invention provides a lead-free solder alloy, which is excellent in drop impact strength and suppresses a decrease in joint strength in high-temperature environment, a solder ball, and a solder joint.

The inventors of the present application have found that addition of a strictly controlled amount of Ag to a Sn-Cu alloy makes it possible to decrease irregularities on solder surfaces with little degradation in ductility. It has been also found that addition of a slight amount of Ge improves a surface texture and heightens metallic luster. In addition, the inventors of the present application have found that addition of Ag and Ge can delay growth of a Cu-Ni-Sn compound on a Ni electrode in high-temperature environment and the joint strength can be maintained, thus having reached the invention.

The invention provides a solder alloy consists of, by mass%: 0.6 to 0.75% of Cu; 0.3 to 1.5% of Ag; more than 0.01% but not more than 0.1% of Ge; and the balance being Sn and incidental impurities.

Preferably, the solder alloy contains 0.5 to 1% of Ag by mass%.

Preferably, the solder alloy contains more than 0.01% but not more than 0.06% of Ge by mass%.

More preferably, the solder alloy is spherically formed into a solder ball.

The invention also provides a solder joint,
in which the solder alloy is joined to a Ni electrode.

The invention greatly solve problems of a decrease in metallic luster attributable to a bad surface texture and failure in mounting of solder balls, without impairing ductility of a Sn-Cu alloy. It can suppress a decrease in joint strength attributable to growth of a compound in high-temperature environment, and ensure reliability in solder joints over a long term after soldering.

### Brief Description of the Drawings

Fig. 1 is an optical micrograph of solder ball surfaces of Sample No. 2 in the invention;
Fig. 2 is a scanning electron micrograph of a joint section of Sample No. 2 in the invention 2 after soldering;
Fig. 3 is a scanning electron micrograph of a joint section of Comparative example No. 13 after soldering;
Fig. 4 is a scanning electron micrograph of a joint section of Comparative example No. 16 after soldering;
Fig. 5 is a scanning electron micrograph of a joint section of Comparative example No. 16 after being annealed at 150°C for 100 hours;
Fig. 6 is a scanning electron micrograph of a joint section of Sample No. 3 in the invention after soldering;
Fig. 7 is a scanning electron micrograph of a joint section of Sample No. 3 in the invention after being annealed at 150°C for 100 hours;
Fig. 8 is a scanning electron micrograph of a joint section of Sample No. 5 in the invention after soldering;
Fig. 9 is a scanning electron micrograph of a joint section of Sample No. 5 in the invention 5 after being annealed at 150°C for 100 hours;
Fig. 10 is a scanning electron micrograph of a joint section of Sample No. 6 in the invention after soldering; and
Fig. 11 is a scanning electron micrograph of a joint section of Sample No. 6 in the invention after being annealed at 150°C for 100 hours.

### Brief Description of the Invention

As described above, the invention has an important feature in an amount of Ag, which does not lower ductility of a Sn-Cu alloy and can improve a surface texture. It is an important advantage that addition of a slight amount of Ge further improves a surface texture and can restrain a decrease in metallic luster. In addition, it is also an advantage that addition of Ag and Ge suppresses growth of a Cu-Ni-Sn compound formed on a solder joint interface to enable maintaining an adequate joint strength also in case of being annealed in high-temperature environment for a long time after being joined to a Ni electrode.

The composition of the invention will be described below.

According to the invention, Cu has an amount of 0.6 to 0.75 mass%. The reason for this is that while addition of Cu to Sn leads to a decrease in melting point, such effect is small in case of being less than 0.6 mass%.

On the other hand, when the amount of Cu exceeds 0.75 mass%, an increase in melting point is brought about, and there is a need of increasing a soldering temperature, so that thermal damage to semiconductor packages is caused.

In case of exceeding 0.75 mass%, Cu becomes surplus and a rough Cu-Ni-Sn compound is formed not only on a solder joint interface but also inside solder, so that ductility of solder is impaired.

When Cu is less than 0.6 mass%, a Cu-Ni-Sn intermetallic compound formed at a solder joint interface is instable and spall off of the interface. The reason is that two kinds of Cu-Ni-Sn intermetallic compounds, (Cu, Ni)₆Sn₅ and (Ni, Cu)₃Sn₄ coexist inhomogeniously at the interface. On the other hand, when the amount of Cu as solder becomes not less than 0.6 mass%, Cu is high enough to allow only (Cu, Ni)₆Sn₅ to exist at the interface, and therefore it does not spall off of a solder joint interface and so a joint strength can be ensured.

In case where a Cu electrode is used, for example, the Cu electrode dissolves into Sn solder up to 0.8 mass% or so at the time of soldering. When the amount of Cu as solder becomes not less than 0.6 mass% the Cu electrode is less corroded so that decrease in joint strength is suppressed.

It is important in the invention that addition of Ag and Ge to a Sn-Cu alloy enables solving a problem related to a surface texture. The cause for worsening a surface texture of the Sn-Cu alloy is that a dendrite structure including irregularities is formed when the alloy solidifies. As solder is cooled more rapidly, a degree of supercooling of solder becomes large and dendrite is formed rapidly so that surface irregularities become large.

Furthermore, the dendrite structure is liable to form cavities among the structures. Such surface irregularities and cavities not only decrease metallic luster but also increase the rate of exposing to an outside air, so that oxidation of solder advances and a further decrease in metallic luster is brought about.

In order to solve the problem of the surface texture, it is effective to strictly control the composition of solder to delay a solidifying rate. This is attained by decreasing a degree of supercooling required at the time of solidification and widening the temperature range in which a solid phase and a liquid phase are coexistent at the time of solidification, that is, a solid-liquid coexistent zone.

Addition of Ag alone is very effective in widening the solid-liquid coexistent zone. Ag also produces an effect of decreasing the melting point of a Sn-Cu alloy.

On the other hand, addition of Ge alone is very effective in reducing the degree of supercooling. Furthermore, addition of Ag and Ge in combination enables further widening the solid-liquid coexistent zone, so that solder having a favorable surface texture is obtained. Thereby, it is possible to greatly improve the problem of metallic luster in visual examination and the problem of failure in mounting of solder balls.

The reason why the amount of Ag is made 0.3 to 1.5 mass% is as follows. Addition of Ag leads to a decrease in melting point and can make the solid-liquid coexistent zone wide. In the case where the amount of Ag is less than 0.3 mass%, the effects described above can be hardly expected, but it can be produced when the amount of Ag is not less than 0.3 mass%. On the other hand, when Ag is added in excess of 1.5 mass%, an intermetallic compound with Sn are formed in solder, so that the alloy is hardened, and the drop impact strength is impaired, and that the solid-liquid coexistent zone is decreased because the resulting composition becomes similar to a Sn-Ag-Cu ternary eutectic composition.

A further preferred amount of Ag is 0.5 to 1.0 mass%, which enables adequately widening a solid-liquid coexistent zone without impairing the ductility of solder and is effective in improving a surface texture. Furthermore, a pinning effect which slows growth of a Cu-Ni-Sn compound on a Ni electrode is effectively demonstrated so that a decrease in strength in high-temperature environment is suppressed.

The reason why the amount of Ge is made more than 0.01 mass% but not more than 0.1 mass% is as follows. In the case where the amount of Ge as solder is not more than 0.01 mass%, an effect of reducing a degree of supercooling is small, so that an improvement of the alloy surface texture cannot be expected so much. Besides, little effect of suppressing a decrease in strength is produced, since such amount of addition does not sufficiently suppress growth by concentrating on grain boundaries of the Cu-Ni-Sn compound on a Ni electrode.

On the other hand, when addition exceeds 0.1 mass%, the drop impact strength is impaired instead, since considerable hardening is brought about. Ge is an alloy element which is more liable to be oxidized than Sn, and excessive addition thereof degrades wettability of solder.

A preferable amount of Ge is more than 0.01 mass% but not more than 0.06 mass%. The reason for this is that when the amount of Ge is not more than 0.06 mass%, a sufficient degree of supercooling for improvement in surface texture is obtained and a decrease in ductility of solder, which is caused by Ge, can be restricted to a minimum, so that an effect of improving the impact strength is easily obtained.

The solder alloy according to the invention described above is very effective in case of being made spherical-shaped to be used as solder balls. In order to join BGA to a mother board, solder balls are mounted on electrodes of BGA to be heated and melted to form solder bumps, while the solder alloy according to the invention can be formed into balls, which have a good surface texture, thus enabling greatly reducing failure in mounting of balls.

While the balls contact mechanically with one another at the time of mounting to make surface oxidation liable to go on, balls having a good surface texture have small ratio of surface to volume, so that it has small surface exposing to an outside air. A probability of mounting itself is high, so that oxidation is inhibited from going on. Since a favorable surface texture is maintained even when the balls are melted to make bumps, it has a favorable look in visual examination and when a laser microscope is used to measure solder bump height, laser beams are stably reflected, so that no measurement error is generated.

The solder alloy and the solder balls according to the invention are further effective in case of being joined to a Ni electrode. The reason therefor is that in the case where a Cu-Ni-Sn compound formed on a Ni electrode is exposed to a high-temperature environment, Ag together with Sn forms a compound to demonstrate a pinning effect Ge concentrates on grain boundaries of the Cu-Ni-Sn compound to suppress its growth thereof, thus enabling lessening a decrease in joint strength in high-temperature environment. A metallic layer of Au, Pd, etc. is in some cases formed on a surface of the Ni electrode with a view to suppressing oxidation of Ni and improving wettability of solder. The same effect is also produced in this case.

### Example 1

After Sn-Cu alloys and alloys formed by adding Ag and Ge thereto were fabricated, they were formed into solder balls having a diameter of 0.3 mm. TABLE 1 indicates solder compositions as examined. A uniform droplet spray method was used in forming. The uniform droplet spray method is one, in which solder alloy is melted in a crucible and melted solder is sprayed from the crucible to manufacture fine balls, and in which the melted solder is vibrated at the time of spray to form the melted metal as sprayed into fine balls having a uniform volume. In addition, the rate of cooling in the forming method was about 100°C/s. The fabricated balls were measured with respect to reflectance and the degree of metallic luster.

**Table 1**

| Alloy No. | | Composition (mass %) | | | |
|---|---|---|---|---|---|
| | | Cu | Ag | Ge | Sn |
| No. 1 | in the invention | 0.7 | 0.3 | 0.1 | balance |
| No. 2 | in the invention | 0.7 | 1 | 0.1 | balance |
| No. 3 | in the invention | 0.7 | 1 | 0.02 | balance |
| No. 4 | in the invention | 0.7 | 1 | 0.05 | balance |
| No. 5 | in the invention | 0.6 | 1 | 0.05 | balance |
| No. 6 | in the invention | 0.75 | 1 | 0.06 | balance |
| No. 11 | comparative example | 0.7 | - | <0.0001 | balance |
| No. 12 | comparative example | 0.7 | 0.3 | <0.0001 | balance |
| No. 13 | comparative example | 0.5 | 1 | <0.0001 | balance |
| No. 14 | comparative example | 0.75 | 1 | <0.0001 | balance |
| No. 15 | comparative example | 0.5 | 3 | <0.0001 | balance |
| No. 16 | comparative example | 0.7 | 1 | 0.01 | balance |

Measurement was made with a spectrophotometer. After solder balls were uniformly arranged on a tray of 30 mm square in a manner not to overlap one another, brightness L* in an L*a*b* color system was measured while striking light on the solder balls. In order to clarify the relationship between a decrease in metallic luster which is caused by a process of surface oxidation, and a surface texture, the solder balls were annealed at 150°C for 100 hours and measured likewise with respect to reflectance. In addition, in order to measure a temperature range of a solid-liquid coexistent zone and a degree of supercooling, the differential thermal analysis was made. In the thermal analysis, both heating and cooling rates were made 2°C/min.

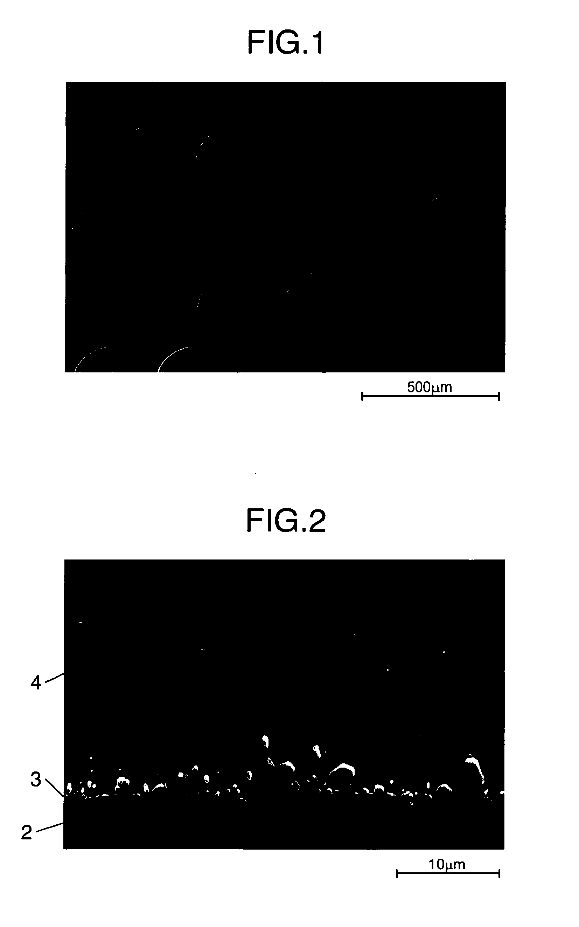

TABLE 2 indicates results of measurements. Fig. 1 shows results of observation of surfaces of solder balls according to Sample No. 2 in the invention with the use of a scanning electron microscope. Comparative example No. 11 was very bad in formability, so that sufficient solder balls for measurement of reflectance could not be obtained. As seen from TABLE 1, addition of Ag enables widening a solid-liquid coexistent zone. However, when an addition exceeds 1 mass% as in Comparative example No. 15, the effect decreases and the degree of supercooling becomes larger than that in case of 1 mass%.

On the other hand, addition of Ge enables widening a solid-liquid coexistent zone somewhat and a degree of supercooling becomes greatly small, so that solder balls are improved in reflectance. In particular, a large difference was found in reflectance in case of being annealed at 150°C for 100 hours such that balls obtained from the solder according to the invention maintained not less than 40% of reflectance even after being annealed for 100 hours. It is also found in Fig. 1 that solder balls very close to perfect balls were obtained from the solder according to the invention. It is found from the above that the solder according to the invention has a favorable surface texture and an enough metallic luster not only after formation but also in high-temperature environment.

**Table 2**

| Alloy No. | | Solidus temperature (°C) | Liquidus temperature (°C) | Solidification starting temperature (°C) | Solid-liquid coexisting zone (°C) | Degree of super-cooling (°C) | reflectivity | |
|---|---|---|---|---|---|---|---|---|
| | | | | | | | As formed | after annealed at 150 °C for 100 hours |
| No. 1 | in the invention | 213 | 231 | 218 | 18 | 13 | 47.6 | 46.6 |
| No. 2 | in the invention | 213 | 229 | 213 | 16 | 16 | 48.1 | 45.7 |
| No. 3 | in the invention | 214 | 230 | 206 | 16 | 24 | 47.5 | 46.8 |
| No. 4 | in the invention | 214 | 229 | 205 | 15 | 24 | 46.3 | 41.6 |
| No. 5 | in the invention | 214 | 229 | 205 | 15 | 24 | 47.5 | 45.1 |
| No. 6 | in the invention | 215 | 232 | 214 | 17 | 18 | 48.2 | 44.2 |
| No. 11 | comparative example | 220 | 227 | 191 | 7 | 36 | - | - |
| No. 12 | comparative example | 213 | 228 | 192 | 15 | 36 | 44.5 | 37.5 |
| No. 13 | comparative example | 213 | 227 | 201 | 14 | 26 | 45.7 | 29.8 |
| No. 14 | comparative example | 213 | 225 | 201 | 12 | 24 | 47.3 | 40.6 |
| No. 15 | comparative example | 214 | 225 | 195 | 11 | 30 | 44.6 | 35.5 |
| No. 16 | comparative example | 214 | 228 | 200 | 14 | 28 | 44.1 | 39.2 |

### Example 2

Subsequently, solder balls having a diameter of 0.3 mm were used to form solder bumps on an electrode (referred below to as Ni electrode), which was provided by performing electrolytic Ni/Au plating on a Cu substrate, and reliability in solder joint was evaluated. The electrode had a diameter of 0.25 mm. Soldering was performed by heating to 240°C and in order to evaluate a deterioration behavior in high-temperature environment, samples, which were annealed at 150°C for 100 hours after soldering, were also fabricated. With respect to the samples fabricated in this manner, spalling of a Cu-Ni-Sn compound formed on a joint interface was confirmed and a cross-sectional structure was observed for measurement of a thickness of the compound. An area of an interface compound in a cross-sectional structure photograph was measured by means of image processing, and a thickness of a Cu-Ni-Sn compound was calculated as a thickness per unit length of a joint interface. TABLE 3 indicates the results.

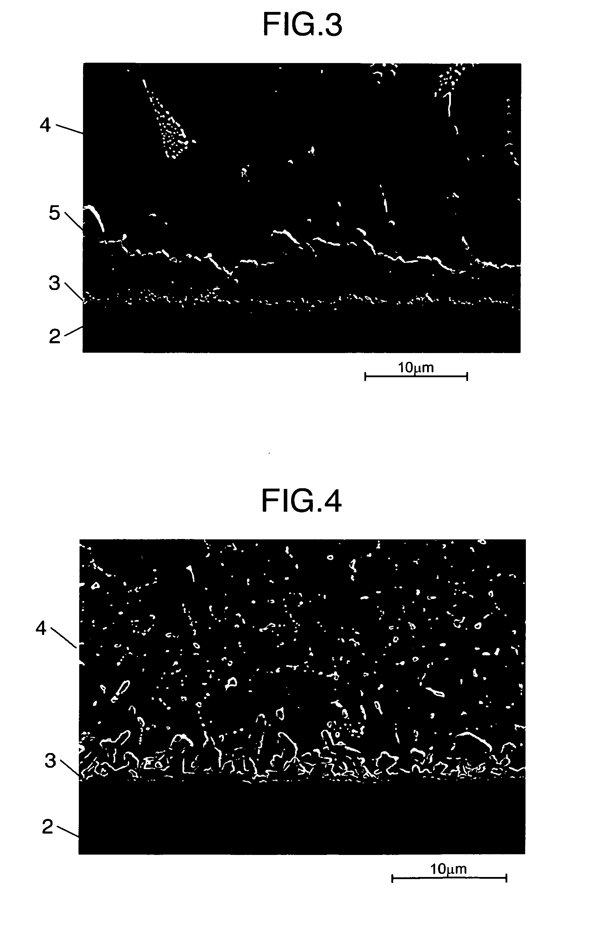

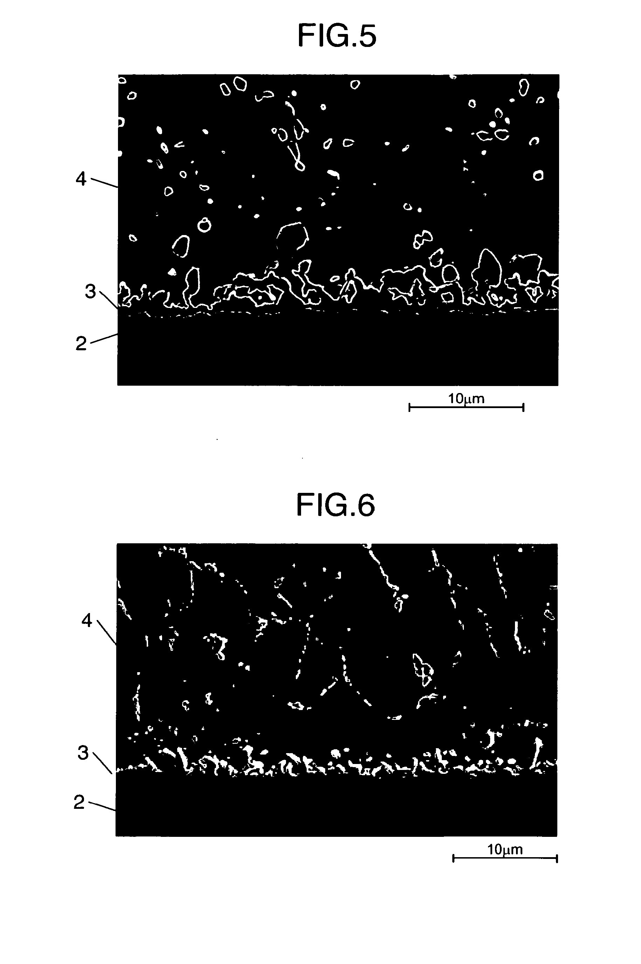

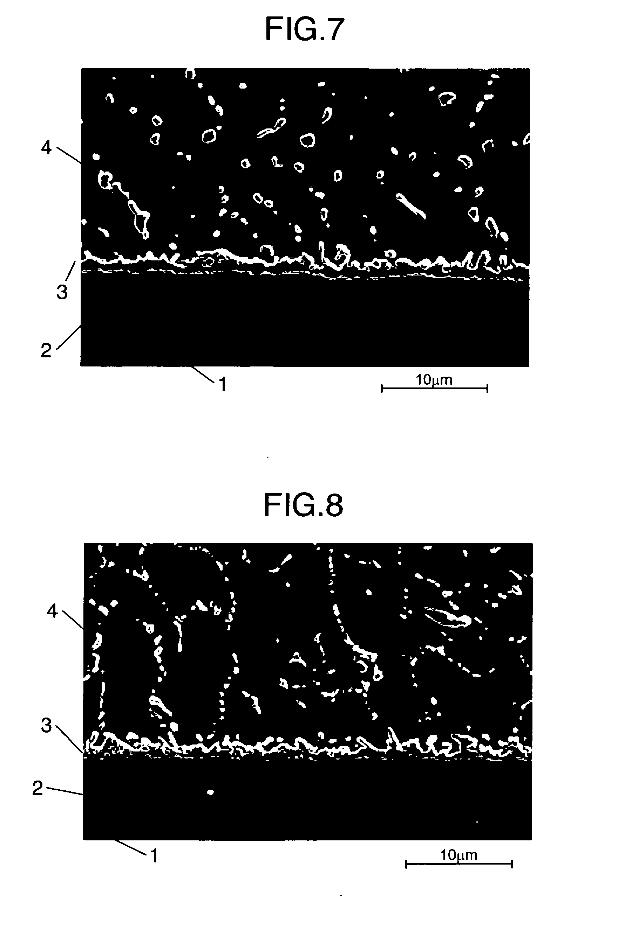

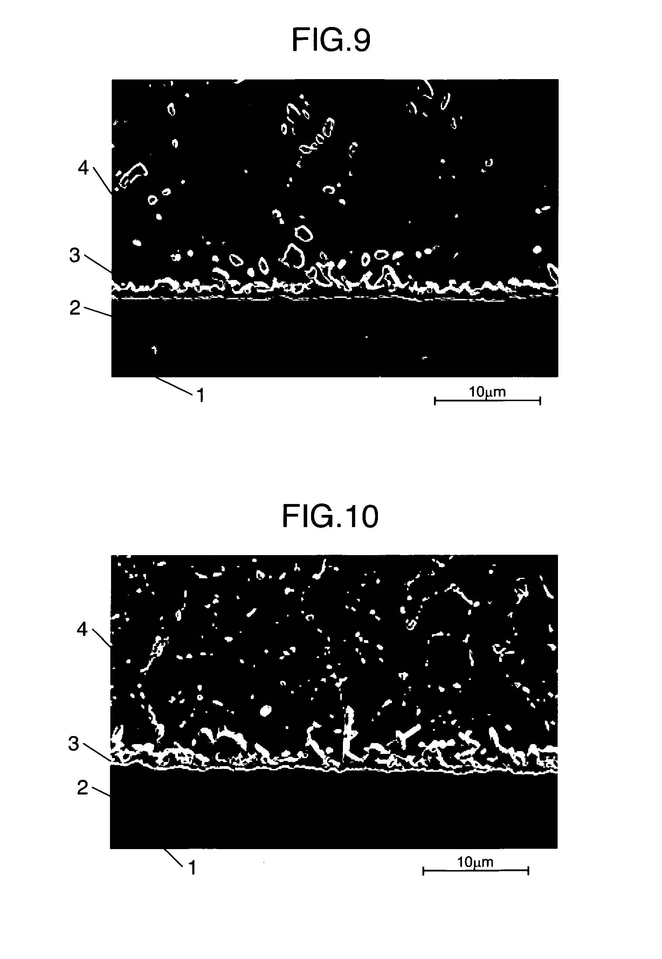

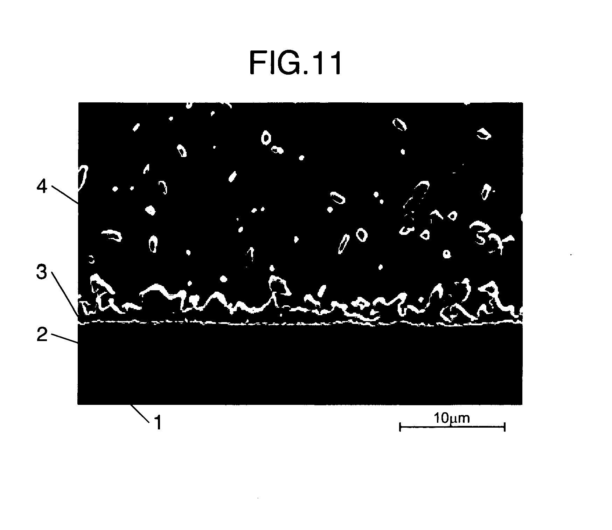

Fig. 2 shows a cross-sectional structure of Sample No. 2 in the invention after soldering, and Fig. 3 shows a cross-sectional structure of Comparative example No. 13. Reference number "1" denotes a Cu substrate; "2" denotes a Ni layer; "3" denotes a Cu-Ni-Sn compound layer; "4" denotes solder; and "5" denotes spalling of the compound. Figs. 4, 6, 8, and 10 show respective cross-sectional structures of Samples Nos. 3, 5, and 6 in the invention and of Comparative example No. 16 after soldering. Figs. 5, 7, 9, and 11 show respective cross-sectional structures of Samples Nos. 3, 5, and 6 in the invention and of Comparative example No. 16, which were annealed at 150°C for 100 hours. With respect to Comparative examples Nos. 13 and 15, a thickness of the compound could not be measured since spalling of the compound 5 as shown in Fig. 3 was generated.

A miniature Charpy impact tester was used in a evaluating method of reliability in joint, in which method a pendulum having a weight of 20 g was caused to strike against a solder bump at a speed of 1 m/s, and the probability of solder joint interfacial fracture was found. Measurement was made for 25 solder bumps. TABLE 3 indicates presence of spalling of a Cu-Ni-Sn compound at the time of soldering and results of measurement of the probability that an interface broke in impact test.

As seen from TABLE 3 and Fig. 2, when an amount of Cu was made 0.6 to 0.75 mass%, spalling of a compound was suppressed. Furthermore, addition of Ge suppressed growth of a Cu-Ni-Sn compound caused when being annealed at 150°C, and fracture in Charpy impact test demonstrated a relatively low probability of interfacial fracture. However, in the case where an addition of Ge is not more than 0.01 mass%, as indicated by Comparative example No. 16, growth of a compound cannot be suppressed because the addition is small, and the probability of interfacial fracture is also high.

As seen from a comparison between Samples Nos. 1 and 2 in the invention and Samples Nos. 3 to 6 in the invention, in the case where an addition of Ge is in excess of 0.01 mass% but not less than 0.06 mass%, degradation of solder in ductility caused by addition of Ge can be restricted to a minimum, so that it is seen that a remarkable predominance is observed in probability of interfacial fracture after soldering.

As apparent from a comparison between Samples Nos. 1 and 2 in the invention, the more an amount of Ag, the larger a pinning effect by Ag₃Sn, so that growth of a Cu-Ni-Sn compound is further inhibited and the probability of interfacial fracture can be reduced also after being annealed at high temperature.

**Table 3**

| Alloy No. | | Compound spalling | Compound thickness (µm) | | Growth thickness (µm) | Probability of interfacial fracture (%) | |
|---|---|---|---|---|---|---|---|
| | | | After soldering | after annealed at 150 °C for 100 hours | | After solderin g | after annealed at 150 °C for 100 hours |
| No. 1 | in the invention | ABSENT | 1.1 | 1.6 | 0.5 | 36 | 80 |
| No. 2 | in the invention | ABSENT | 1.4 | 1.5 | 0.1 | 24 | 72 |
| No. 3 | in the invention | ABSENT | 1.0 | 1.2 | 0.2 | 12 | 40 |
| No. 4 | in the invention | ABSENT | 1.3 | 1.7 | 0.4 | 8 | 80 |
| No. 5 | in the invention | ABSENT | 0.9 | 1.1 | 0.2 | 0 | 84 |
| No. 6 | in the invention | ABSENT | 1.5 | 1.8 | 0.3 | 8 | 84 |
| No. 12 | comparative example | ABSENT | 1.7 | 2.4 | 0.7 | 40 | 100 |
| No. 13 | comparative example | ABSENT | - | - | - | 84 | 96 |
| No. 14 | comparative example | PRESENT | 1.6 | 2.2 | 0.6 | 64 | 100 |
| No. 15 | comparative example | ABSENT | - | - | - | 88 | 96 |
| No. 16 | comparative example | PRESENT | 1.1 | 1.8 | 0.6 | 64 | 96 |

### Example 3

In order to evaluate a drop impact strength, bound-level drop test was carried out on the basis of the JEDEC Standards JESD22-B111. Test substrates for the drop test were fabricated by using solder balls having a diameter of 0.3 mm to form solder bumps on BGA having 345 Ni electrodes and then using a solder paste to join the solder bumps to a mother board.

Sn-3Ag-0.5Cu (by mass%) as generally used was used for the solder paste. Subsequently, after a test substrate was fixed horizontally to a drop table, it was dropped 30 times from a level, at which level a drop impact applied to the drop table was 1500 G to form a half-sine wave of 0.5 ms, while being maintained in a horizontal posture. In the drop test, bias of a daisy-chain circuit formed between BGA and the mother board was measured to find electrical failure. For respective compositions of solder, two test substrates, that is 30 BGAs in total, were evaluated, since 15 BGAs were mounted every test substrate.

Times of drop corresponding to the 5% probability of failure were found from results of the test by weibull plotting the relationship between the number of cumulative failures of BGA and times of drop. TABLE 4 indicates results of times of drop corresponding to the 5% probability of failure in the drop test. As apparent from a comparison between Comparative example No. 15 and others, the drop impact strength is greatly improved owing to a decrease in Ag content, and solder according to the invention is improved relative to Comparative example No. 13 in drop life by strictly controlling additions of Cu, Ag, and Ge. In particular, solder capable of withstanding drops of not less than 40 times is obtained by making an addition of Ge in excess of 0.01 mass% but not more than 0.06 mass%, such as Samples Nos. 3, 5, and 6 in the invention.

**Table 4**

| Alloy No. | | Number of drops corresponding to probability of 5% failure |
|---|---|---|
| No. 1 | in the invention | 35 |
| No. 2 | in the invention | 39 |
| No. 3 | in the invention | 48 |
| No. 5 | in the invention | 52 |
| No. 6 | in the invention | 44 |
| No. 13 | comparative example | 28 |
| No. 15 | comparative example | 2 |

## Claims

1. A solder alloy consisting of, by mass%:
0.6 to 0.75% of Cu;
0.3 to 1.5% of Ag;
more than 0.01% but not more than 0.1% of Ge; and
the balance being Sn and incidental impurities.

2. The solder alloy according to claim 1, wherein the solder alloy contains 0.5 to 1% of Ag by mass%.

3. The solder alloy according to claim 1 or 2, wherein the solder alloy contains more than 0.01% but not more than 0.06% of Ge by mass%.

4. A solder ball formed spherically of a solder alloy, the solder alloy consisting of, by mass%:
0.6 to 0.75% of Cu;
0.3 to 1.5% of Ag;
more than 0.01% but not more than 0.1% of Ge; and
the balance being Sn and incidental impurities.

5. The solder ball according to claim 4, wherein the solder alloy contains 0.5 to 1% of Ag by mass%.

6. The solder ball according to claim 4 or 5, wherein the solder alloy contains more than 0.01% but not more than 0.06% of Ge by mass%.

7. A solder joint, in which a solder alloy is joined to a Ni electrode, the solder alloy consisting of, by mass%:
0.6 to 0.75% of Cu;
0.3 to 1.5% of Ag;
more than 0.01% but not more than 0.1% of Ge; and
the balance being Sn and incidental impurities.

8. The solder joint according to claim 7, wherein the solder alloy contains 0.5 to 1% of Ag by mass%.

9. The solder joint according to claim 7 or 8, wherein the solder alloy contains more than 0.01% but not more than 0.06% of Ge by mass%.
